# FASCICULE DE BREVET EUROPEEN

(11) **EP 0 283 077 B1**
(45) Date de publication et mention de la délivrance du brevet: **16.06.1993**
(21) Numéro de dépôt: 88200393.2
(22) Date de dépôt: 02.03.1988
(51) Int. Cl.: H03M 5/16, H04L 25/497

(54) **Dispositif de décodage de signaux codés en duobinaire**
Einrichtung zur Dekodierung duobinärer kodierter Signale
Apparatus for decoding dual binarily coded signals

(30) Priorité: 06.03.1987 FR 8703085
(43) Date de publication de la demande: 21.09.1988
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Lamnabhi, Moustanir Société Civile S.P.I.D., F-75007 Paris (FR); Salembier, Philippe Société Civile S.P.I.D., F-75007 Paris (FR)
(74) Mandataire: Landousy, Christian

(56) Documents cités:
- EP-A- 0 133 480
- EP-A- 0 209 839
- US-A- 4 118 686
- IEEE JOURNAL ON SELECTED AREAS IN COMMUNICATIONS, vol. SAC-4, no. 1, janvier 1986, pages 142-154, IEEE, New York, US; P.G. GULAK et al.: "VLSI structures for viterbi receivers: Part I - General theory and applications"
- ELECTRONICS & COMMUNICATIONS IN JAPAN, vol. 65-B, no. 8, août 1982, pages 47-55, Silver Spring, Maryland, US; T. YAMADA et al.: "A method of coding for correlative transmission systems and its application to a continuous phase modulation system"
- IBM JOURNAL OF RESEARCH AND DEVELOPMENT, janvier 1971, pages 64-74, New York, US; H. KOBAYASHI: "Application of probabilistic decoding to digital magnetic recording systems"
- IEEE TRANSACTIONS ON COMMUNICATIONS, vol. COM-34, no. 5, mai 1986, pages 454-461, IEEE, New York, US; R.W. WOOD et al.: "Viterbi detection of class IV partial response on a magnetic recording channel"
- THE BELL SYSTEM TECHNICAL JOURNAL, vol. 51, no. 2, février 1972, pages 493-505, American Telephone and Telegraph Co., New York, US; M.J. FERGUSON: "Optimal reception for binary partial response channels"
- IEEE TRANSACTIONS ON INFORMATION THEORY, vol. IT-18, no. 3, mai 1972, pages 363-378, IEEE, New York, US; G.D. FORNEY, Jr.: "Maximum-likelihood sequence estimation of digital sequences in the presence of intersymbol interference"

## Description

La présente invention concerne un dispositif de décodage des signaux présents en sortie d'un canal de transmission après codage en duobinaire d'une séquence de signaux numériques binaires. Ce dispositif de décodage de signaux duobinaires est utilisable notamment dans les récepteurs de signaux de télévision selon le standard dit D2-MAC/paquets.

L'introduction de la couleur, dans le domaine de la télévision, a été, à l'époque, réalisée en ajoutant au signal de luminance Y des signaux dits de différence de couleur, ou de chrominance. Mais l'étude du spectre du signal vidéo ainsi obtenu a montré que les informations de luminance et de chrominance pouvaient se mélanger, donnant lieu à des interférences connues sous le nom de cross-luminance et de cross-chrominance.

Le standard de transmission MAC, mis au point plus récemment, remédie à cet inconvénient. Ce nouveau standard, destiné à assurer la diffusion d'un ensemble d'informations à la fois analogiques (luminance, chrominance), et numériques (son, signaux de synchronisation, éventuellement commentaires ou éléments de sous-titrage,...) dans les limites de bande d'un canal de transmission, prévoit plus précisément un multiplexage temporel de ces différentes composantes à l'intérieur d'une ligne de télévision, par exemple de la façon suivante :
- informations numériques : 10 microsecondes ;
- chrominance : 17,5 microsecondes ;
- luminance : 15 microsecondes.

Il existe plusieurs versions de ce standard MAC. La France a pour sa part retenu comme standard de diffusion la version dite D2-MAC/paquets, dans laquelle le débit binaire est de l'ordre de 10 Mbits/s et le codage utilisé est duobinaire. Malheureusement, les performances de ce standard D2-MAC/paquets dans des conditions difficiles de réception (par exemple les liaisons satellites avec un faible rapport porteuse sur bruit) sont limitées par la partie audio du système de transmission permettant la mise en oeuvre dudit standard. En effet des test ont montré que, pour un rapport signal/bruit d'environ 13 dB sur une liaison en modulation d'amplitude, le décodage des signaux numériques dans la partie réception du système de transmission est réalisé avec un taux d'erreur de 10⁻³, ce qui est considéré comme étant la limite de réception pour le son, alors que l'image reste acceptable.

Le but de l'invention est de proposer un dispositif de décodage de signaux duobinaires dans lequel on remédie à cette limitation pour accroître les performances du standard D2-MAC/paquets.

A cet effet, l'invention concerne un dispositif de décodage tel que défini dans le préambule et caractérisé en ce qu'il comprend :
(A) un premier étage de détermination et de construction de chemins binaires, comprenant lui-même :
   (a) des première, deuxième et troisième mémoires de stockage des probabilités conditionnelles respectives P(y/0), P(y/1), P(y/2) destinées à recevoir à l'instant kT, k étant le rang des échantillons numériques successifs, un signal duobinaire déterminé y lorsqu'un signal duobinaire x = 0, 1 ou 2 a été émis en amont du canal de transmission, lesdites mémoires de stockage étant adressées en parallèle par le signal y reçu afin de délivrer chacune la probabilité correspondante ;
   (b) des premier et deuxième circuits de sélection et de stockage des deux probabilités conditionnelles correspondant, à l'instant (k+1)T, aux deux séquences - ou chemins - binaires les plus vraisemblables, ces deux circuits étant prévus le premier en sortie des première et deuxième mémoires de stockage et le second en sortie des deuxième et troisième mémoires de stockage ;
   (c) un circuit de reconstruction progressive des chemins binaires ainsi sélectionnés et de sélection de celui des deux qui est le plus vraisemblable, comprenant lui-même :
      (c₁) deux registres à décalage pour le stockage respectif des deux séquences binaires correspondant aux deux vraisemblances sélectionnées respectivement par les circuits de sélection et de stockage ;
      (c₂) un comparateur des sorties des deux registres de stockage des vraisemblances sélectionnées respectivement par les circuits de sélection et de stockage, en vue de la sélection de la plus grande de ces deux vraisemblances et de celle des deux séquences binaires stockées dans lesdits registres à décalage qui lui correspond ;
(B) un deuxième étage d'interdiction de dépassement de la capacité de stockage dans lesdits circuits de sélection et de stockage dudit premier étage, prévu en sortie de ces deux circuits pour constituer une boucle de rétroaction sur les entrées desdits circuits, et comprenant lui-même :
   (d) un circuit d'aiguillage placé en sortie dudit comparateur pour sélectionner sur commande de celui-ci l'une des deux vraisemblances précédemment sélectionnées par chaque circuit de sélection et de stockage ;
   (e) un circuit de calcul d'une fraction de la vraisemblance sélectionnée par ledit circuit d'aiguillage ;
   (f) un ensemble de trois soustracteurs en parallèle placés respectivement entre la sortie des mémoires de stockage des probabilités conditionnelles et les entrées des circuits de sélection et de stockage.

En effet, après plusieurs cycles d'exécution des opérations décrites de détermination et de construction de chemins binaires, les moyens de stockage desdits circuits de sélection et de stockage de probabilité ne suffisent plus pour contenir les informations reçues. La rétroaction proposée résoud alors ce problème de dépassement de capacité : en effet, puisqu'on opère, dans ce dispositif selon l'invention, sur des valeurs relatives et non sur des valeurs absolues, ladite rétroaction entraîne dans lesdits moyens de stockage un décalage suffisant pour éviter les dépassements de capacité.

Les tests réalisés aussi bien par simulation que par mise en oeuvre réelle ont montré qu'une telle structure conduisait effectivement à des performances supérieures à celles des décodeurs traditionnels. L'article "VLSI structures for Viterbi receivers : part I, general theory and applications", de P.G. Gulak et E. Shwedyk, paru dans la revue "IEEE Journal on Selected Areas in Communications", Vol.SAC-4, n°1, janvier 1986, pp. 142-154, décrit quelques structures de dispositifs mettant en oeuvre l'algorithme de Viterbi, mais ignore le problème, mentionné plus haut, de la saturation de capacité lors de la reconstruction des chemins binaires les plus vraisemblables, et ne peut donc échapper aux limitations de performances déjà évoquées.

Dans un mode de réalisation avantageux, le dispositif de décodage selon l'invention est caractérisé en ce que les premier et deuxième circuits de sélection et de stockage de probabilité conditionnelle comprennent chacun :
(b₁) un premier et un deuxième multiplieur ou respectivement un troisième et un quatrième multiplieur recevant sur leur première entrée les sorties des mémoires de stockage de probabilité et calculant les grandeurs P(y/0). LI(0,k) et P(y/1). LI(1,k), ou respectivement P(y/1).LI(0,k) et P(y/2).LI(1,k), grandeurs dans lesquelles LI(0,k) et LI(1,k) sont les vraisemblances associées aux deux chemins précédemment sélectionnés par ces mêmes circuits de sélection et de stockage et fournies aux deuxièmes entrées desdits multiplieurs ;
(b₂) un comparateur des sorties des deux multiplieurs correspondants, dit premier ou deuxième comparateur respectivement, pour la sélection de la plus grande des deux vraisemblances présentes en sortie des premier et deuxième multiplieurs, ou respectivement des troisième et quatrième multiplieurs ;
(b₃) un premier ou respectivement un deuxième registre de stockage desdites vraisemblances associées ainsi sélectionnées, dont la sortie est renvoyée vers les deuxièmes entrées des multiplieurs.

Dans une variante de ce mode de réalisation, les probabilités sont remplacées par leur logarithme décimal, ce qui permet d'utiliser des additionneurs à la place des multiplieurs.

Les particularités et avantages de l'invention apparaîtront maintenant de façon plus détaillée dans la description qui suit et dans les dessins annexés, donnés à titre d'exemple non limitatif et dans lesquels :
- la figure 1 montre le schéma de principe d'un codeur duobinaire ;
- la figure 2a montre un type de séquence duobinaire possible à la sortie de ce codeur, et les figures 2b et 2c montrent deux types de séquences impossibles ;
- la figure 3 montre un exemple de réalisation du dispositif de décodage selon l'invention ;
- la figure 4 montre la succession des états du codeur duobinaire à l'émission.

Avant de décrire le décodeur selon l'invention, on rappellera notamment que le principe du codeur duobinaire prévu dans la partie émission de la chaîne de transmission, en amont du canal de transmission, repose sur la réalisation de l'addition de deux bits successifs des signaux codés en binaire. Le signal duobinaire ainsi constitué traverse alors le canal de transmission, où un bruit additif vient le perturber. De cette perturbation, il résulte qu'à la réception, au lieu d'avoir un signal numérique duobinaire net, on dispose d'un signal fluctuant autour des niveaux qui ont été émis.

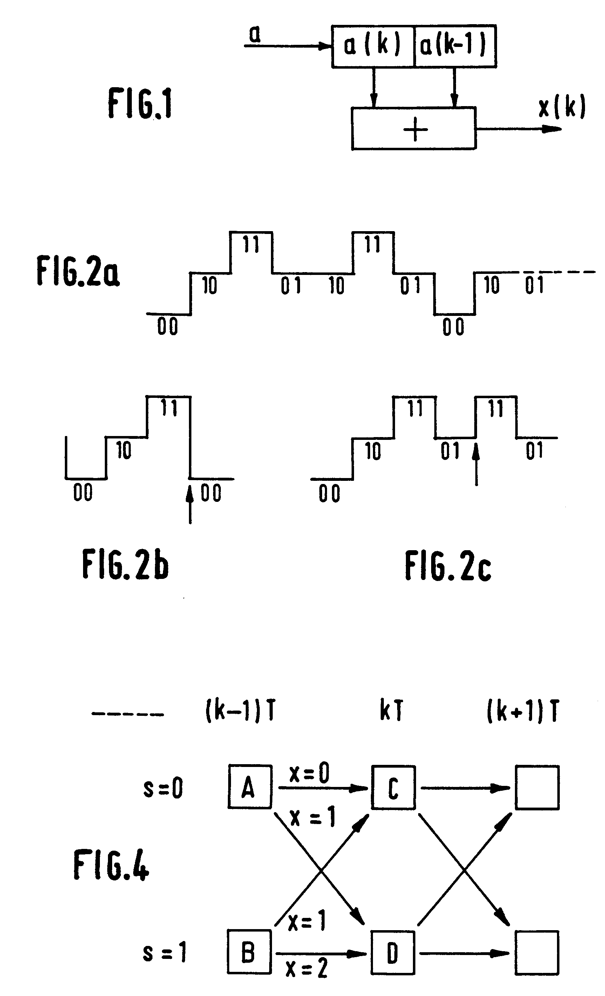

A la sortie du codeur représenté sur la figure 1, le signal x(k), où k est le rang des échantillons numériques binaires ou duobinaires, résulte de l'addition des échantillons binaires successifs a(k-1) et a(k), égaux à 0 ou à 1, et prend lui-même la valeur 0, 1, ou 2. La correspondance entre les valeurs de a(k-1) et a(k) et celles de x(k) est donc la suivante : aux paires de valeurs 00, 01, 10, 11 correspondent respectivement les valeurs de x(k) 0, 1, 1, et 2.

La figure 2a représente un type de séquence possible à la sortie du codeur, tandis que les figures 2b et 2c montrent au contraire deux exemples de séquences impossibles, l'ensemble a(k), a(k-1) ne pouvant passer directement de la valeur 11 à la valeur 00 sans être passé par la valeur 01, ni de la valeur 01 à la valeur 11 sans être passé par la valeur 10.

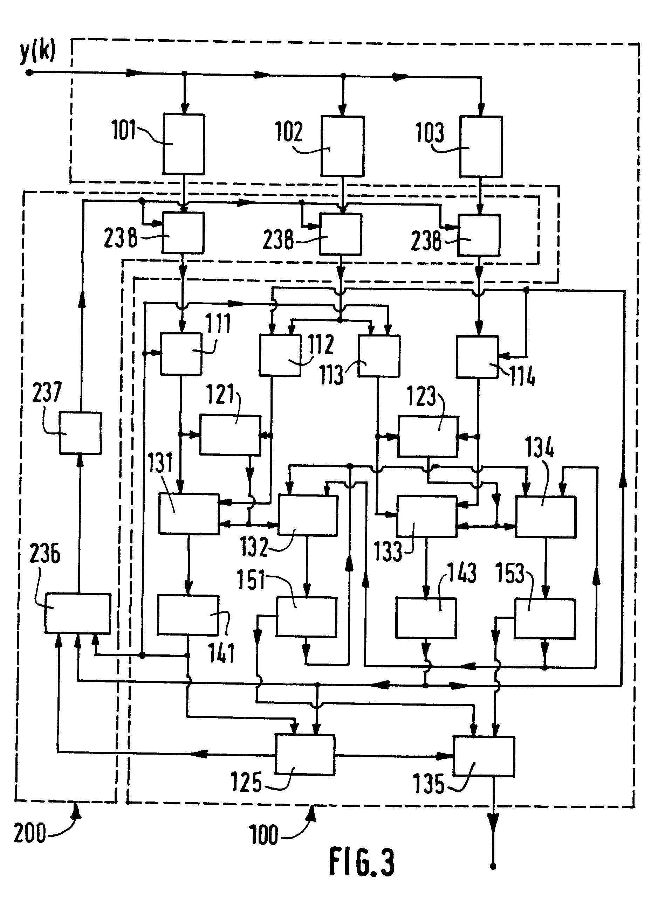

Ces précisions ayant été apportées, on va maintenant décrire le décodeur selon l'invention. Ce décodeur comprend, comme le montre la figure 3, deux types de circuits. Un premier ensemble de circuits constitue un étage 100 de détermination et de construction des deux chemins binaires ayant les vraisemblances les plus grandes. Un deuxième ensemble de circuits constitue un étage 200 d'interdiction de dépassement de capacité. Le décodeur est situé en sortie d'un canal de transmission non représenté à l'entrée duquel le signal émis est noté x(k). Le signal reçu par le décodeur en sortie du canal est, lui, noté y(k). Comme on a utilisé à l'émission un codage duobinaire, x(k) est donc, on le rappelle, égal ici à 0, à 1, ou à 2.

On a vu que ce signal reçu en correspondance à chacun des signaux numériques émis était perturbé lors de sa transmission et fluctuait donc autour de ces niveaux numériques. Pour déterminer à quel signal émis (0, 1, ou 2) correspond le signal y(k) reçu, un décodeur traditionnel utiliserait le principe d'une comparaison à deux seuils. Selon que y(k) est au-dessous du seuil inférieur, entre les deux seuils, ou au-dessus du seuil supérieur, ce décodeur traditionnel déciderait que le signal émis était respectivement 0, 1 ou 2. Dans un tel décodeur, le résultat des comparaisons est alors bien évidemment totalement indépendant d'un signal reçu au suivant, c'est-à-dire que la décision relative à un échantillon x(k) émis, compte tenu de la valeur de y(k) correspondante effectivement reçue, n'a pas d'influence sur la décision relative à l'échantillon x(k+1) auquel correspond, à la réception, une valeur y(k+1). De cette indépendance, il résulte qu'on pourrait détecter des transitions 0 à 2 par exemple, alors que, on l'a vu, certaines situations ne peuvent jamais survenir. Le décodeur traditionnel n'utilise donc pas la dépendance qui, en fait, existe entre les symboles transmis.

Le décodeur selon l'invention met à profit cette redondance qui existe dans le signal duobinaire et, en utilisant l'algorithme dit de Viterbi, s'attache plus précisément à estimer, en fonction de la séquence Y(D) de signaux duobinaires reçue, la meilleure séquence X(D) d'échantillons duobinaires émise. Par meilleure séquence, on entend ici celle qui est la plus probable, c'est-à-dire celle dont les échantillons duobinaires successifs ..., x(k-1), x(k), x(k+1), etc... sont avec le maximum de vraisemblance ceux qui ont conduit à la séquence reçue ..., y(k-1), y(k), y (k+1), etc...

On rappellera donc que l'algorithme de Viterbi repose sur le principe de la comparaison des vraisemblances associées aux séquences estimées. On considère à cet effet pour chaque signal reçu y les trois probabilités P(y/0), P(y/1), P(y/2), qui représentent les probabilités d'avoir reçu effectivement y sachant que l'échantillon duobinaire émis x était respectivement 0, 1, ou 2. On a par ailleurs représenté sur la figure 4 la succession des états du codeur duobinaire à l'émission. Si a(k), a(k+1), etc... sont les échantillons binaires successifs à l'entrée du codeur, on désigne respectivement les états s(k), s(k+1), s(k+2), etc... du codeur comme étant la valeur de l'échantillon binaire précédent a(k-1), a(k), a(k+1), etc... . Les noeuds du treillis désignent alors ces états, et les transitions x(k) entre noeuds désignent l'échantillon duobinaire effectivement transmis.

A l'instant (k-1)T, où T désigne la durée de chaque symbole, on considère alors les deux séquences ou chemins binaires qui arrivent l'un en A avec une vraisemblance α, et l'autre en B avec une vraisemblance β. A l'instant suivant kT, un signal y(k) a été reçu par le décodeur. On peut alors calculer les probabilités conditionnelles P(y/0), P(y/1), P(y/2) correspondantes. Le registre du décodeur qui contient a(k) ne peut prendre que deux états 0 ou 1. A l'instant kT, on ne peut donc aboutir par exemple au noeud D que de deux manières différentes qui sont :
(a) le chemin qui aboutit en B, avec ensuite apport d'un niveau haut (maintien à 1 du contenu du registre a(k)), ce chemin ayant pour probabilité β x P(y/2) ;
(b) le chemin qui aboutit en A et se dirige ensuite vers D (avec mise à 1 du contenu du registre a(k)), ce chemin ayant pour probabilité α x P(y/1) (les probabilités peuvent être multipliées les unes par les autres, puisque, dans le cas présent, les symboles binaires sont des variables aléatoires indépendantes et les échantillons de bruit sont décorrélés).

Des deux vraisemblances α.P(y/1) et β.P(y/2) qui viennent d'être déterminées, on ne garde que la plus grande, qui correspond au chemin le plus vraisemblable pour arriver au point D. De la même manière, deux chemins binaires arrivent au point C :
(a) celui qui aboutit au point B et se dirige ensuite vers C (avec mise à 0 du contenu du registre a(k)), et qui a pour probabilité β.P(y/1) ;
(b) celui qui aboutit au point A, avec ensuite apport d'un niveau bas (maintien à 0 du contenu du registre a(k)), et qui a pour probabilité α.P(y/0). Là encore, on ne garde que le chemin binaire dont la vraisemblance est la plus grande.

Deux chemins binaires complets peuvent ainsi être progressivement construits de noeud en noeud du treillis. Il faut enfin choisir, par une décision, celui des deux chemins ainsi construits qui présente le maximum de vraisemblance. L'algorithme de Viterbi est optimal si l'on garde en mémoire la séquence infinie transmise. En réalité, compte tenu des caractéristiques du codage duobinaire, on constate que les deux chemins binaires construits sont presque sûrement confondus à partir d'un bit déterminé, le cinquième ou le sixième bit, ce qui, on va le voir, évite un stockage important préalablement à la décision.

La mise en oeuvre du processus qui vient d'être décrit est en effet réalisée de la façon suivante. Les signaux duobinaires qui se succèdent en série en sortie du canal de transmission sont reçus par trois mémoires mortes 101, 102, 103 dites PROM (en anglais : Programmable Read-Only Memory), et en permettent l'adressage. Ces mémoires PROM 101 à 103 contiennent respectivement les probabilités P(y/0), P(y/1), P(y/2) déterminées par les caractéristiques de la transmission, telles que le bruit de transmission, les interférences intersymboles, et.... . Dans le cas présent, on stocke de préférence dans ces mémoires non pas les probabilités, mais leur logarithme décimal, afin de permettre l'utilisation d'additionneurs au lieu de multiplieurs en aval desdites mémoires.

A la suite des mémoires PROM 101 à 103, adressées par les signaux duobinaires reçus, sont donc prévus, dans le mode de réalisation préférentiel décrit, quatre additionneurs 111 à 114. Les additionneurs 111 et 112 calculent log₁₀(P(y/0). LI(0,k)) et log₁₀(P(y/1). LI(1,k)), et les additionneurs 113 et 114 calculent log₁₀ (P(y/1).LI(0,k)) et log₁₀(P(y/2).LI(1,k), en fonctionnant donc comme des multiplieurs. Dans ces expressions, les valeurs LI(0,k) et LI(1,k) sont les vraisemblances des deux chemins précédemment sélectionnés, et sont contenues dans deux registres cités ci-dessous.

Deux comparateurs 121 et 123 comparent alors, le premier, la sortie de l'additionneur 111 et celle de l'additionneur 112 et, le second, la sortie de l'additionneur 113 et celle de l'additionneur 114. Le résultat de la comparaison effectuée dans le comparateur 121 commande la sélection de l'une des deux vraisemblances P(y/0).LI(0,k) ou P(y/1).LI(1,k) (celle qui est la plus élevée) et du chemin binaire correspondant, tandis que, de façon similaire, le résultat de la comparaison effectuée dans le comparateur 123 commande la sélection de l'une des deux vraisemblances P(y/1).LI(0,k) ou P(y/2).LI(1,k) et du chemin binaire correspondant. La vraisemblance sélectionnée à la suite de la commande par le comparateur 121 est alors stockée dans l'un des deux registres qui viennent d'être mentionnés, un registre 141, où elle constitue désormais la valeur LI(0,k+1) qui est renvoyée vers l'une des deux entrées des deux additionneurs 111 et 113 pour un nouveau déroulement des opérations précédemment décrites. De même, la vraisemblance sélectionnée par le comparateur 123 est stockée dans l'autre registre, un registre 143 où elle constitue la valeur LI(1,k+1) qui est renvoyée vers l'une des deux entrées des deux additionneurs 112 et 114.

Cette double détermination de chemins binaires les plus vraisemblables permet alors la reconstruction proprement dite de ces deux chemins dits survivants. En effet, des registres à décalage 151 et 153 stockent les séquences binaires que constituent ces chemins, de façon tronquée bien entendu puisqu'on a vu plus haut que les deux chemins étaient presque certainement confondus à partir d'un nombre déterminé de bits. A chaque cycle de déroulement des opérations précédemment décrites, un 0 est ajouté au chemin survivant se terminant au noeud 0 du treillis, et un 1 au chemin survivant se terminant au noeud 1. En même temps se produit à l'autre extrémité de chacun de ces registres à décalage 151 et 153 l'extraction du bit le plus ancien.

Celui de ces deux bits les plus anciens auquel est associé la plus grande vraisemblance est sélectionné pour constituer le signal de sortie estimé. Cette sélection est permise par un comparateur 125 qui reçoit sur ses deux entrées les contenus respectifs des deux registres 141 et 143, c'est-à-dire les vraisemblances préalablement sélectionnées par les comparateurs 121 et 123, et valide, selon celle de ces deux vraisemblances qui est la plus élevée (celle contenue dans le registre 141 ou celle contenue dans le registre 143), soit le bit le plus ancien extrait du registre à décalage 151, soit le bit le plus ancien extrait du registre à décalage 153. Ce bit sélectionné constitue le signal de sortie du dispositif, et la succession de ces bits sélectionnés à chaque cycle d'opérations reconstitue une estimation de la séquence binaire émise.

La sélection opérée par l'intermédiaire des comparateurs 121 et 123, puis par l'intermédiaire du comparateur 125 est en fait réalisée à l'aide de circuits d'aiguillage 131, 133, 135. Le circuit d'aiguillage 131 reçoit en effet d'une part sur deux premières entrées les vraisemblances (en fait leur logarithme, comme on l'a vu plus haut, dans le cas de l'exemple décrit) P(y/0).LI(0,k) et P(y/1).LI(1,k) délivrées par les additionneurs 111 et 112, et d'autre part sur une troisième entrée le signal de commande émis par le comparateur 121. La sortie du circuit d'aiguillage 131, qui est constituée par la vraisemblance sélectionnée, est reliée à l'entrée du registre 141.

De même, le circuit d'aiguillage 133 reçoit sur deux premières entrées les vraisemblances P(y/1).LI(0,k) et P(y/2).LI(1,k) et, sur une troisième, le signal de commande émis par le comparateur 123, et la sortie de ce circuit 133 est reliée à l'entrée du registre 143. Les deux vraisemblances ainsi sélectionnées sont celles qui sont envoyées vers les deux entrées du comparateur 125, pour détermination de la plus grande d'entre elles. Dans le même temps, le circuit d'aiguillage 135 reçoit sur deux premières entrées les deux bits les plus anciens des registres à décalage et délivre en sortie, sur commande provenant de la sortie du comparateur 125, le bit sélectionné comme étant le signal de sortie du dispositif, c'est-à-dire le bit estimé pour un bit déterminé émis.

La sélection opérée par les comparateurs 121 et 123 conduit à commander non seulement les circuits d'aiguillage 131 et 133, mais également les circuits d'aiguillage 132 et 134 à l'aide d'une entrée commune d'une part aux circuits 131 et 132, et d'autre part aux circuits 133 et 134. Chacun de ces circuits d'aiguillage 132 et 134 reçoit d'une part la sortie du registre 151 et d'autre part celle du registre 153, et envoie vers le registre à décalage 151 ou 153 correspondant celle de ces deux sorties qui a été sélectionnée par la commande en provenance du comparateur 121 ou 123 respectivement.

Le dispositif décrit ci-dessus est équipé d'un circuit d'interdiction de dépassement de capacité des registres 141 et 143. Ce circuit comprend un circuit d'aiguillage 236 qui est placé en parallèle sur le comparateur 125, en ce sens qu'il reçoit les mêmes deux vraisemblances sélectionnées par les comparateurs 121 et 123, c'est-à-dire les vraisemblances disponibles en sortie des registres 141 et 143. Ce circuit d'aiguillage 236 délivre alors, sur commande du comparateur 125, l'une de ces deux vraisemblances, par exemple la plus faible. Pour éviter le dépassement de capacité des registres, une valeur liée à celle de la vraisemblance ainsi délivrée est retranchée de la sortie des mémoires, à l'aide de trois soustracteurs 238 placés entre la sortie de ces mémoires et l'entrée des additionneurs 111 à 114. Ladite valeur est une fraction calculée de la vraisemblance, obtenue par exemple par division de celle-ci par deux, par trois, etc..., dans un circuit de calcul 237 qui est ici un diviseur, étant donné, en tout cas, que cette valeur retranchée à l'aide des soustracteurs 238 dépend du retard pris par les signaux concernés lors de l'exécution des opérations dans le circuit d'aiguillage 236, dans ce circuit de calcul 237, et dans ces soustracteurs 238 deux-mêmes, et doit être d'autant plus élevée que ce retard est plus important.

Bien entendu, la présente invention n'est pas limitée à l'exemple de réalisation ci-dessus décrit et représentée, à partir duquel des variantes peuvent être proposées sans pour cela sortir du cadre de l'invention. On remarquera notamment que, du fait que les deux chemins binaires construits sont presque sûrement confondus à partir d'un bit déterminé, si les registres 151 et 153 sont suffisamment grands, leurs bits de sortie (c'est-à-dire le bit le plus ancien de chacun) sont effectivement égaux, ce qui permet d'omettre le circuit d'aiguillage 135.

## Revendications

1. Dispositif de décodage des signaux présents en sortie d'un canal de transmission après codage en duobinaire d'une séquence de signaux numériques binaires, caractérisé en ce qu'il comprend :
(A) un premier étage de détermination et de construction de chemins binaires, comprenant lui-même :
(a) des première, deuxième et troisième mémoires (101, 102, 103) de stockage des probabilités conditionnelles respectives P(y/0), P(y/1), P(y/2) destinées à recevoir à l'instant kT, k étant le rang des échantillons numériques successifs, un signal duobinaire déterminé y lorsqu'un signal duobinaire x = 0, 1 ou 2 a été émis en amont du canal de transmission, lesdites mémoires de stockage étant adressées en parallèle par le signal y reçu afin de délivrer chacune la probabilité correspondante ;
(b) des premier et deuxième circuits de sélection et de stockage des deux probabilités conditionnelles correspondant, à l'instant (k+1)T, aux deux séquences - ou chemins - binaires les plus vraisemblables, ces deux circuits étant prévus le premier en sortie des première et deuxième mémoires de stockage (101, 102) et le second en sortie des deuxième et troisième mémoires de stockage (102, 103) ;
(c) un circuit de reconstruction progressive des chemins binaires ainsi sélectionnés et de sélection de celui des deux qui est le plus vraisemblable, comprenant lui-même :
(c₁) deux registres à décalage (151, 153) pour le stockage respectif des deux séquences binaires correspondant aux deux vraisemblances sélectionnées respectivement par les circuits de sélection et de stockage ;
(c₂) un comparateur (121) des sorties des deux registres de stockage des vraisemblances sélectionnées respectivement par les circuits de sélection et de stockage, en vue de la sélection de la plus grande de ces deux vraisemblances et de celle des deux séquences binaires stockées dans lesdits registres à décalage qui lui correspond ;
(B) un deuxième étage (236, 237, 238) d'interdiction de dépassement de la capacité de stockage dans lesdits circuits de sélection et de stockage dudit premier étage, prévu en sortie de ces deux circuits pour constituer une boucle de rétroaction sur les entrées desdits circuits, et comprenant lui-même :
(d) un circuit d'aiguillage (236) placé en sortie dudit comparateur pour sélectionner sur commande de celui-ci l'une des deux vraisemblances précédemment sélectionnées par chaque circuit de sélection et de stockage ;
(e) un circuit (237) de calcul d'une fraction de la vraisemblance sélectionnée par ledit circuit d'aiguillage ;
(f) un ensemble de trois soustracteurs en parallèle (238) placés respectivement entre la sortie des mémoires de stockage des probabilités conditionnelles et les entrées des circuits de sélection et de stockage.

2. Dispositif selon la revendication 1, caractérisé en ce que les premier et deuxième circuits de sélection et de stockage de probabilité conditionnelle comprennent chacun :
(b₁) un premier et un deuxième multiplieur ou respectivement un troisième et un quatrième multiplieur, recevant sur leur première entrée les sorties des mémoires de stockage de probabilité et calculant les grandeurs P(y/0). LI(0,k) et P(y/1). LI(1,k), ou respectivement P(y/1).LI(0,k) et P(y/2).LI(1,k), grandeurs dans lesquelles LI(0,k) et LI(1,k) sont les vraisemblances associées aux deux chemins précédemment sélectionnés par ces mêmes circuits de sélection et de stockage et fournies aux deuxièmes entrées desdits multiplieurs ;
(b₂) un comparateur des sorties des deux multiplieurs correspondants, dit premier ou deuxième comparateur respectivement, pour la sélection de la plus grande des deux vraisemblances présentes en sortie des premier et deuxième multiplieurs, ou respectivement des troisième et quatrième multiplieurs ;
(b₃) un premier ou respectivement un deuxième registre de stockage desdites vraisemblances associées ainsi sélectionnées, dont la sortie est renvoyée vers les deuxièmes entrées des multiplieurs.

3. Dispositif selon la revendication 1, caractérisé en ce que le premier et le deuxième circuits de sélection et de stockage de probabilité conditionnelle comprennent chacun :
(b₁) un premier et un deuxième additionneur (111, 112) ou respectivement un troisième et un quatrième additionneur (113, 114), recevant sur leur première entrée les sorties des mémoires de stockage de probabilité et calculant les grandeurs log₁₀(P(y/0). LI(0,k)) et log₁₀(P(y/1). LI(1,k)), ou respectivement log₁₀(P(y/1).LI(0,k)) et log₁₀(P(y/2).LI(1,k)), grandeurs dans lesquelles LI(0,k) et LI(1,k) désignent les vraisemblances associées aux deux chemins précédemment sélectionnés par ces mêmes circuits de sélection et de stockage et fournies sous forme logarithmique aux deuxièmes entrées desdits additionneurs ;
(b₂) un comparateur des sorties des deux additionneurs correspondants, dit premier ou deuxième comparateur (121, 123) respectivement, pour la sélection de la plus grande desdites deux vraisemblances associées ;
(b₃) un premier ou respectivement un deuxième registre (141, 143) de stockage du logarithme décimal desdites vraisemblances associées ainsi sélectionnées, dont la sortie est renvoyée vers les deuxièmes entrées des additionneurs.

## Claims

1. Device for decoding signals received at the output of a transmission channel after duobinary encoding of a sequence of binary digital signals, characterized in that it comprises:
(A) a first stage for determining ad constructing binary paths, comprising:
(a) first, second and third storage memories (101, 102, 103) for storing respective conditional probabilities P(y/0), P(y/1), P(y/2) receiving at the instant kT, wherein k is the order of consecutive digital samples, a predetermined duobinary signal y when a duobinary signal x = 0, 1 or 2 has been transmitted upstream of the transmission channel, said storage memories being addressed in parallel by the received signal y in order that each memory supplies the corresponding probability.
(b) first and second selection ad storage circuit for two conditional probabilities, which at the instant (k+1)T correspond to the most probable binary sequences - or paths -, the first circuit being provided at the output of the first and second storage memories (101, 102) and the second at the output of the second and third storage memories(102, 103).
(c) a circuit for progressively reconstructing the binary paths thus selected and for selecting the most probable path of the two, which circuit comprises:
(c₁) two shift registers (151, 153) for the respective storage of the two binary sequences corresponding to the two probabilities selected by the selection and the storing circuit, respectively;
(c₂) a comparator (121) for comparing the output signals of the two probability storage registers which are respectively selected by the selection and storage circuits, for the purpose of selecting the larger of these two probabilities and the one of the two binary sequences being stored in said shift registers which corresponds thereto.
(B) a second stage (236, 237. 238) which inhibits exceeding of the storage capacity in said selection and storing circuits of the first stage, provided at the output of said two circuits to form a feed-back loop at the inputs of said circuits, which stage comprises:
(d) a switching circuit (236) connected to the output of the comparator for selecting, under the control of this comparator, one of the two probabilities previously selected by each selection and storage circuit;
(e) a circuit (237) for calculating a fraction of the probability selected by said switching circuit;
(f) a set of three parallel-arranged subtractors (238) which are provided between, respectively, the output of the conditional probability storage memories and the inputs of the selection and storage circuits.

2. A device as claimed in Claim 1, characterized in that the first and second selection and conditional probability storage circuits each comprise:
(b₁) a first and a second respectively a third and a fourth multiplier, which at their first inputs receive the output from the probability storage memories and calculate the quantities P(y/0). LI(0,k). and P(y/1). LI(1,k) or P(y/1). LI(0,k) and P(y/2). LI(1,k), respectively, in which quantities LI(0,k) and LI(1,k) designate probabilities which are associated with said two paths which were previously selected by these same selection and storage circuits and which probabilities applied to second inputs of said multipliers;
(b₂) a first and a second comparator for comparing the output values of the two corresponding multipliers, for the purpose of selecting the larger of the two probabilities present at the output of the first and the second multiplier and of the third and the fourth multiplier, respectively;
(b₃) a first and a second storage register, respectively, for said associated probabilities thus selected, whose outputs are fed back to the second inputs of the multiplier.

3. A device as claimed in Claim 1, characterized in that the first and second selection and conditional probability storage circuits each comprise:
(b₁) a first and a second adder (111, 112) and, respectively, a third and a fourth adder (113, 114), which at their first input receive the output signals from the probability storage memories and calculate the quantities log₁₀(P(y/0) .LI(0,k)), log₁₀(P(y/1). LI(1,k), and log₁₀(P(y/1) .LI(0,k) and log₁₀(P(y/2).LI(1,k), respectively, in which quantities LI(o,k) and LI(1,k) designate probabilities which are associated with said two paths which were previously selected by these same selection and storage circuits which probabilities are logarithmically applied to the second inputs of said multipliers;
(b₂) a first and a second comparator (121, 123) for comparing the output values of the two corresponding adders, for the purpose of selecting the larger of the said two associated probabilities;
(b₃) a first and a second storage register (141, 143), for storing the decimal logarithm of the associated probabilities thus selected, whose outputs are fed back to the second inputs of the adders.

## Patentansprüche

1. Anordnung zum Decodieren der am Ausgang eines Übertragungskanals vorhandenen Signale nach ihrer Duobinärcodierung in eine Folge binärer digitaler Signale,
dadurch gekennzeichnet, daß sie folgende Elemente enthält:
(A) eine erste Binärweg-Bestimmungs- und Aufbaustufe, die besteht aus:
(a) ersten, zweiten und dritten Speichern (101, 102, 103) zum Speichern der jeweiligen bedingten Wahrscheinlichkeiten P(y/0), P(y/1), P(y/2) zum Empfangen eines bestimmten Duobinärsignals y zum Zeitpunkt kT, worin k die Reihenfolge der aufeinanderfolgenden digitalen Abtastungen ist, wenn ein Duobinärsignal x = 0, 1 oder 2 stromaufwärts im Übertragungskanal ausgesandt ist, wobei die Speicher vom Signal y zum Ausgeben einer jeden der entsprechenden Wahrscheinlichkeit parallel adressiert werden,
(b) ersten und zweiten Schaltungen zum Wählen und Speichern der zwei entsprechenden bedingten Wahrscheinlichkeiten zum Zeitpunkt (k+1)T in den wahrscheinlichsten zwei binären Folgen - oder auf den wahrscheinlichsten zwei binären Wegen -, wobei die erste dieser zwei Schaltungen an den Ausgängen des ersten und des zweiten Speichers (101, 102) und die zweite an den Ausgängen des zweiten und des dritten Speichers (102, 103) vorgesehen sind,
(c) einer progressigen Rekonstruktionsschaltung der auf diese Weise gewählten Binärwege zum Wahlen jenes Weges der zwei, der am wahrscheinlichsten ist, die besteht aus:
(c₁) zwei Schieberegistern (151, 153) zum jeweiligen Speichern von zwei Binärfolgen entsprechend zwei jeweils durch die Wähl- und Speicherschaltungen gewählten Wahrscheinlichkeiten,
(c₂) einem Komparator (121) der Ausgänge der zwei Speicherregister der jeweils durch die Wähl- und Speicherschaltungen gewählten Wahrscheinlichkeiten im Hinblick auf die Wahl der größten dieser zwei Wahrscheinlichkeiten und jener der zwei gespeicherten Binärfolgen in den Schieberegistern, die damit übereinstimmt,
(B) eine zweite Stufe (236. 237, 238) zum Verhindern des Überschreitens der Speicherkapazität in den Wahl- und Speicherschaltungen der ersten Stufe am Ausgang dieser zwei Schaltungen zum Bilden einer Rückkopplungsschleife an den Eingängen dieser Schaltungen, und die besteht aus:
(d) einer Verzweigungsschaltung (236) am Ausgang des Komparators zum Wählen einer der zwei zuvor von jeder Wähl- und Speicherschaltung gewählten Wahrscheinlichkeiten auf Befehl des Komparators,
(e) einer Schaltung (237) zum Berechnen eines Bruchteils der von der Verzweigungsschaltung gewählten Wahrscheinlichkeit,
(f) einer Gruppe von drei Subtrahierern (238) in Parallelschaltung zwischen dem Ausgang der Speicher für die bedingten Wahrscheinlichkeiten und den Eingängen der Wähl- und Speicherschaltungen.

2. Anordnung nach Anspruch 1,
dadurch gekennzeichnet, daß die ersten und zweiten Schaltungen zum Wählen und Speichern bedingter Wahrscheinlichkeit je folgende Elemente enthalten:
(b₁) einen ersten und einen zweiten Multiplizierer bzw. einen dritten und eine vierten Multiplizierer, die an ihrem ersten Eingang die Speicherausgangssignale zum Speichern der Wahrscheinlichkeit und zum Berechnen der Größen P(y/0).LI(0,k) und P(y/1).LI(1,k) bzw. P(y/1).LI(0.k) und P(y/2).LI(1,k) empfangen, in welchen Größen LI(0,k) und LI(1,k) die Wahrscheinlichkeiten sind, die den zwei Wegen zugeordnet sind, die zuvor von denselben Wähl- und Speicherschaltungen gewählt und den zweiten Eingängen der Multiplizierer zugeführt wurden,
(b₂) einen Komparator der Ausgänge der zwei entsprechenden Multiplizierer, die mit erstem bzw. zweitem Komparator bezeichnet wird, zum Wählen der größten der zwei vorhandenen Wahrscheinlichkeiten am Ausgang der ersten und zweiten Multiplizierer bzw. der dritten und vierten Multiplizierer,
(b₃) ein erstes bzw. ein zweites Speicherregister für die Speicherung der so gewählten zugeordneten Wahrscheinlichkeiten, deren Ausgangssignal an die zweiten Eingänge der Multiplizierer gelegt wird.

3. Anordnung nach Anspruch 1,
dadurch gekennzeichnet, daß die ersten und zweiten Schaltungen zum Wählen und Speichern bedingter Wahrscheinlichkeit je folgende Elemente enthalten:
(b₁) einen ersten und einen zweiten Addierer (111, 112) bzw. einen dritten und einen vierten Addierer (113, 114), die an ihrem ersten Eingang die Speicherausgangssignale zum Speichern der Wahrscheinlichkeit und zum Berechnen der Größen log₁₀P(y/0).LI(0,k) und log₁₀P(y/1).LI(1,k) bzw. log₁₀P(y/1).LI(0.k) und log₁₀P(y/2).LI(1,k) empfangen, in welchen Größen LI(0,k) und LI(1,k) die Wahrscheinlichkeiten sind, die den zwei Wegen zugeordnet sind, die zuvor von denselben Wähl- und Speicherschaltungen gewählt und den zweiten Eingängen der Multiplizierer zugeführt wurden,
(b₂) einen Komparator der Ausgänge der zwei entsprechenden Addierer, die mit erstem bzw. zweitem Komparator (121, 123) bezeichnet wird, zum Wählen der größten der zwei zugeordneten Wahrscheinlichkeiten,
(b₃) ein erstes bzw. ein zweites Speicherregister (141, 143) für die Speicherung des Dezimallogarithmus der so gewählten zugeordneten Wahrscheinlichkeiten, deren Ausgangssignal an die zweiten Eingänge der Addierer gelegt wird.
